(19) Europäisches Patentamt
European Patent Office
Office européen des brevets

(11) **EP 4 057 502 B1**

(12) **EUROPÄISCHE PATENTSCHRIFT**

(45) Veröffentlichungstag und Bekanntmachung des Hinweises auf die Patenterteilung:
**28.01.2026 Patentblatt 2026/05**

(21) Anmeldenummer: **22157419.7**

(22) Anmeldetag: **18.02.2022**

(51) Internationale Patentklassifikation (IPC):
***H02P 29/60*** *(2016.01)*

(52) Gemeinsame Patentklassifikation (CPC):
**H02P 29/60**

(54) **SYSTEM UND VERFAHREN ZUM SCHÄTZEN DER MOTORTEMPERATUR EINES MOTORS**

SYSTEM AND METHOD FOR ESTIMATING THE MOTOR TEMPERATURE OF A MOTOR

SYSTÈME ET PROCÉDÉ D'ESTIMATION DE LA TEMPÉRATURE DE MOTEUR D'UN MOTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.03.2021 DE 102021105493**

(43) Veröffentlichungstag der Anmeldung:
**14.09.2022 Patentblatt 2022/37**

(73) Patentinhaber: **ebm-papst Mulfingen GmbH & Co. KG**
**74673 Mulfingen (DE)**

(72) Erfinder: **WYSTUP, Ralph**
**74653 Künzelsau (DE)**

(74) Vertreter: **Staeger & Sperling Partnerschaftsgesellschaft mbB Sonnenstraße 19 80331 München (DE)**

(56) Entgegenhaltungen:
**EP-A1- 3 107 204          US-A- 5 600 575**
**US-A1- 2020 341 062     US-A1- 2020 400 355**
**US-B1- 6 349 023**

**Beschreibung**

Die vorliegende Erfindung betrifft ein System und Verfahren zum Ermitteln bzw. Schätzen der Motortemperatur eines Motors, insbesondere zum Schutz der Motorüberhitzung. Ferner betrifft die Erfindung einen Motor ausgebildet mit einem solchen System.

Bekannte Methoden zur Temperaturerfassung der Motortemperatur sind zum Beispiel neben dem Einbau von Sensoren in die Wicklung, die Bestimmung der Wicklungstemperatur über Zustandsschätzer (Kalmanfilter, Gradientenmethode) aus den Motor-Differentialgleichungen, die direkte Messung des Wicklungswiderstandes im Betrieb durch Einkoppelung einer Messspannung oder die Berechnung der Motortemperatur anhand thermischer Netzwerkmodelle des Motors.

In jüngerer Zeit wird zunehmend versucht die Temperatur im Inneren eines Elektromotos zu bestimmen, ohne dabei jedoch einen Temperatursensor oder eine ähnliche Messeinrichtung im Motor d. h. im elektromechanischen Teil des Motors verbauen zu müssen.

Aus der DE 10 2008 040 725 A1 ist z. B. ein Verfahren zur Ermittlung einer Rotortemperatur einer permanenterregten Synchronmaschine bekannt, bei dem ein Schätzwert für die Rotortemperatur mittels eines ein thermisches Modell der Synchronmaschine enthaltenden Kalman-Filters ermittelt wird.

Aus der EP 2977733 A1 ist ein weiteres Verfahren zur Ermittlung einer Wicklungstemperatur einer Erregerwicklung einer fremderregten Synchronmaschine mittels eines Kalman-Filters bekannt. Dabei wird für einen Anfangszeitpunkt ein erster Temperaturschätzwert der Wicklungstemperatur vorgegeben, zu verschiedenen auf den Anfangszeitpunkt folgenden Messzeitpunkten werden jeweils eine an der Erregerwicklung anliegende elektrische Erregerspannung und ein durch die Erregerwicklung fließender elektrischer Erregerstrom erfasst, und für jeden Messzeitpunkt wird rekursiv ein aktualisierter Temperaturschätzwert in Abhängigkeit von der zu dem Messzeitpunkt erfassten Erregerspannung dem zu dem Messzeitpunkt erfassten Erregerstrom und einem bisherigen Temperaturschätzwert gebildet.

Aus der DE 102019105081 A1 ist eine Vorrichtung zum Ermitteln der Temperatur einer Wicklung einer mit einem Stator und einem Rotor ausgebildeten Drehfeldmaschine bekannt, umfassend wenigstens ein erstes Kalman-Filter (K1) zur Berechnung der Temperatur sowie eine Drehfeldregelung zur Vektorregelung der Drehfeldmaschine mit wenigstens einem id-Stromregler, der ausgebildet ist, der Wicklungsspannung ein hochfrequentes Spannungssignal (HF) aufzuprägen um daraus einen Wicklungsstrom mit einem hochfrequent überlagertem Stromanteil für die Wicklung zu erhalten, welcher dem Kalman-Filter (K1) zugeführt wird, wobei das Kalman-Filter (K1) ein Hochfrequenzmodell des Motors besitzt, um daraus den Hochfrequenzwiderstand der Wicklung und daraus wiederum mittels einer Rechenfunktion die Wicklungstemperatur zu ermitteln.

Die im Stand der Technik bekannten Methoden besitzen allerdings auch jeweils spezifische Nachteile bei der Implementierung oder im Anwendungsfall, so dass weiterhin ein Bedürfnis besteht, eine zuverlässige Überwachung der Motortemperatur im Inneren eines Elektromotos zu bestimmen, ohne dabei jedoch einen Temperatursensor oder eine ähnliche Messeinrichtung im Motor d. h. im elektromechanischen Teil des Motors verbauen zu müssen.

Weiterer druckschriftlicher Stand der Technik im vorliegenden technischen Gebiet ist in den Dokumenten EP 3 107 204 A1, US 2020/341 062 A1, US 5 600 575 A, US 6 349 023 B1 und US 2020/400 355 A1 offenbart. Insbesondere offenbart das Dokument EP 3 107 204 A1 eine Motorleistungs-Umwandlungsvorrichtung, die mit einer elektronischen thermischen Funktion zum Überlastschutz eines Motors versehen ist, die einen Gesamtverlust-Zeitintegrationszähler aufweist, der, wenn die Zeitintegration eines Gesamtverlustes des Motors konstant wird, einen integrierten Wert ausgibt, der die Wicklungstemperatur des Motors simuliert, und wenn der integrierte Wert einen vorbestimmten Schwellenwert erreicht, ein Signal ausgibt, um den Betrieb des Motors zu stoppen.

Der vorliegenden Erfindung liegt daher die Aufgabe zugrunde, vorbesagte Nachteile zu überwinden und ein effizientes System und Verfahren zum Erfassen der Motortemperatur eines Motors, insbesondere zum Schutz der Motorüberhitzung vorzuschlagen.

Grundgedanke der Erfindung ist dabei, einen Sensor derart zu gestalten, dass dieser basierend auf einem thermischen Modell, welches das thermische Motorverhalten abbildet, der elektrischen Eingangsleistung und vorzugsweise auch der Wellendrehzahl sowie einer Referenztemperatur die Temperatur im Inneren des Motors ermittelt.

Erfindungsgemäß wird hierzu ein System zur Überwachung der Temperatur eines Motors mit einer elektromechanisch antreibbaren Motorwelle vorgeschlagen, umfassend einen "virtuellen" Sensor, der basierend auf einem thermischen Modell, welches das thermische Verhalten des Motors beschreibt, ein Messmittel zur Bestimmung der elektrischen Eingangsleistung des Motors und einem Messmittel zur Erfassung der Wellendrehzahl der Motorwelle, wobei ferner eine Auswertevorrichtung vorgesehen ist, die ausgebildet ist, aus der Eingangsleistung, einer Referenztemperatur $T_{Ref}$, der ermittelten Wellendrehzahl n und dem thermischen Modell die jeweils aktuelle Motortemperatur des Motors zu ermitteln.

In einer besonders vorteilhaften Ausführungsform der Erfindung ist vorgesehen, dass das thermische Modell (MOD) ein Differentialgleichungssystem ist oder umfasst, welches das thermische Verhalten des Motors nachbildet. Somit kann man durch Lösen des Differentialgleichungssystems bei Einspeisung der dazu benötigten Werte, dieses lösen und darüber zu einer Motortemperaturberechnung gelangen. Insofern kann man den auf dem Differentialgleichungssystembasierenden Sensor auch als virtuellen Sensor auffassen.

In ebenfalls bevorzugter Weise zeichnet sich das verwendete Differentialgleichungssystem durch eine spezifische Eigenschaft aus, dass es mehrere alternative Lösungsverfahren zur Ermittlung der Temperatur zulässt, insbesondere mittels nummerischer Integration oder mittels analoger Berechnungsmethode auf Basis eines analogen Rechners oder mittels analoger Berechnungsmethode mittels eines Modells umfassend passive Bauelemente. Denkbar wären grundsätzlich auch weitere Lösungsverfahren.

Ein weiterer Aspekt der vorliegenden Erfindung betrifft neben dem System zur Überwachung der Temperatur auch ein Verfahren zur Überwachung der Temperatur. Erfindungsgemäß ist hierzu ein Verfahren vorgesehen, insbesondere mit einem wie zuvor beschriebenen System unter Verwendung eines Differentialgleichungssystems (DGL), welches das thermische Verhalten des Motors beschreibt, mit den folgenden Schritten:

a. Erfassung der elektrischen Eingangsleistung des Motors;

b. Berechnen der mechanischen Wellenleistung aus der erfassten Drehzahl des Motors und Ermitteln des korrespondierenden Drehmoments des Motors;

c. Berechnen der thermische Verlustleistung, die zur Erhöhung der Motortemperatur führt, insbesondere durch Subtraktion der mechanischen Wellenleistung von der elektrischen Eingangsleistung;

d. die ermittelte thermische Verlustleistung wird als Eingangsgröße zur Lösung des Differentialgleichungssystems in das Differentialgleichungssystem eingespeist und daraus eine Temperaturerhöhung berechnet, insbesondere unter Verwendung einer zusätzlichen Referenztemperatur $T_{ref}$, die zur Temperaturerhöhung addiert wird, um daraus die Motortemperatur zu bestimmen.

In einer ersten vorteilhaften Ausführungsform der Erfindung ist vorgesehen, dass genannte Verfahren, dadurch gekennzeichnet ist, dass die Lösung des Differentialgleichungssystems zur Ermittlung der Motortemperatur durch numerische Integration (z.B. nach Euler,...,Runge Kutta etc.) erfolgt.

Bei zwei alternativen Ausführungsformen ist vorgesehen, dass die Lösung des Differentialgleichungssystems zur Ermittlung der Motortemperatur jeweils analog berechnet wird, indem entweder eine korrespondierende Schaltung nach der Art eines Analogrechners mit entsprechenden Rechnerbausteinen verwendet wird oder alternativ auf Basis geeigneter RC-Bausteine und passiven Bauelementen. Die Strom- und/oder Spannungsquellen können mit OP oder Transistorschaltungen bei der Verwendung passiver RC-Systeme verwendet werden.

In den genannten Ausführungsformen ist es von Vorteil, wenn die Erfassung der elektrischen Eingangsleistung des Motors durch Messung einer Zwischenkreisspannung und eines Zwischenkreisstroms und durch Multiplikation der beiden Messwerte, vorzugsweise mittels Mikrorechner erfolgt oder aus der Zwischenkreisspannung gewonnen wird. Hierzu werden bei den später genannten Ausführungsbeispielen mögliche Implementierungen näher erläutert.

Erfindungsgemäß erfolgt die Ermittlung der Drehzahl durch Messung der Frequenz der Strangspannung und Ermittlung des korrespondierende Drehmomentes aus einem entsprechend gespeicherten Kennfeld, oder mittels des q-Anteils des Stroms iq oder mithilfe eines Dehnungsmessstreifens, insbesondere für den Fall der Ausführungsform bei der numerischen Integration.

Erfindungsgemäß wird mittels einer analogen Frequenz-Spannungswandlung aus einer zu messenden Strangspannung des Motors eine der Drehzahl proportionalen Spannung erzeugt, um daraus die Wellenleistung zu ermitteln. Alternative Wege zur Ermittlung der Wellenleistung sind ebenfalls denkbar.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:

Fig.1 eine schematische Darstellung einer Ausführungsform der Erfindung;

Fig.2 eine beispielhafte Umsetzung der Berechnungsmethode mit der Software Matlab Simulink (ohne echte Datenerfassung) zur automatischen Coderzeugung,

Fig.3 eine beispielhafte Umsetzung der Berechnungsmethode mit der Software Matlab Simulink (mit konkreter Datenerfassung) zur automatischen Coderzeugung,

Fig. 4 eine RC-Kettenschaltung zur Erläuterung eines Realisierungsentwurfes mittels Differentialgleichungen,

Fig. 5    Realisierungsansatz eines CRCR-Netzwerks mit einer Spannungsquelle und

Fig. 6    Realisierungsansatz eines CRCR-Netzwerks mit einer Spannungsquelle

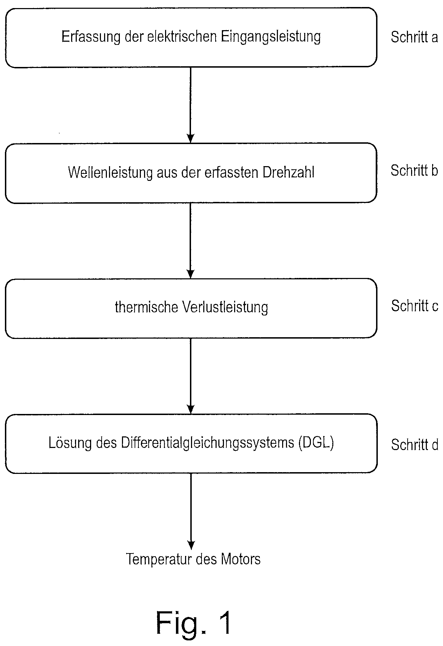

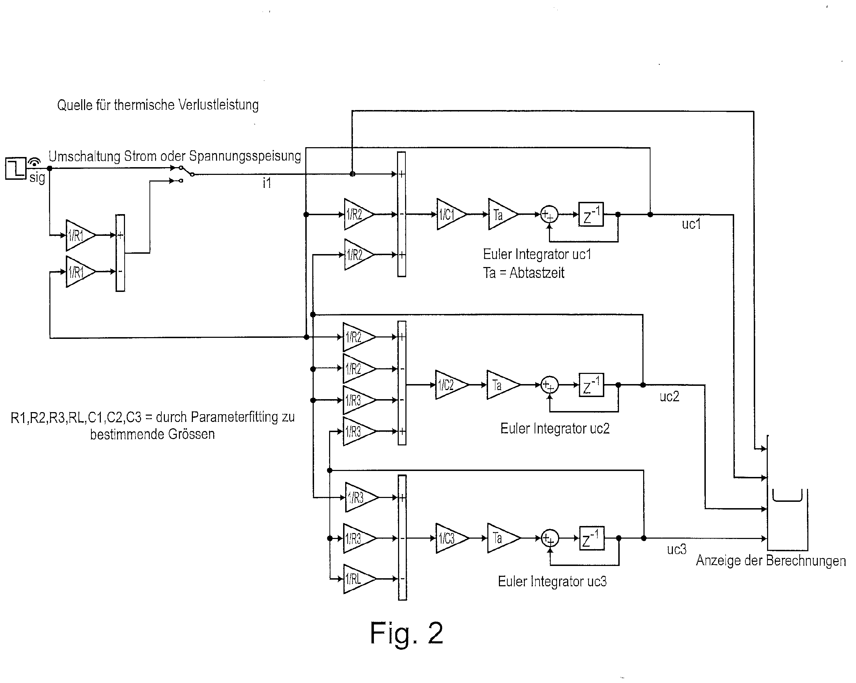

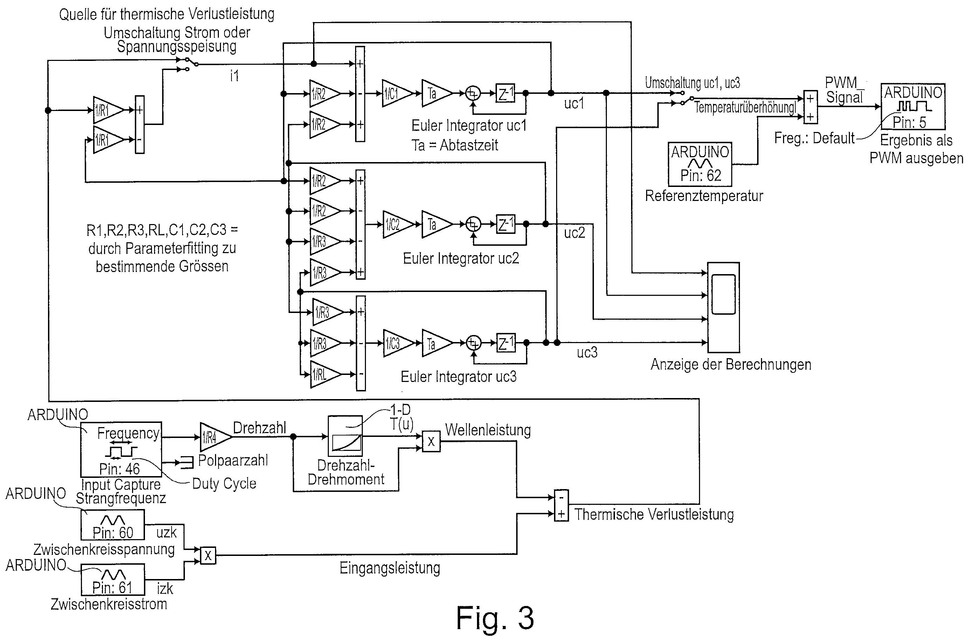

Im Folgenden wird die Erfindung anhand einer beispielhaften Ausführungsform mit Bezug auf die Figuren 1 bis 3 näher beschrieben, wobei gleiche Bezugszeichen auf gleiche funktionale und/oder strukturelle Merkmale hinweisen.
Es werden zunächst drei alternative Ausführungsvarianten mit Bezug auf die Fig. 1 beschrieben. In der Figur 1 sind die folgenden Verfahrensschritte zur Bestimmung der Motortemperatur gezeigt:

Schritt a:    Erfassung der elektrischen Eingangsleistung des Motors;
Schritt b:    Berechnen der mechanischen Wellenleistung aus der erfassten Drehzahl des Motors und Ermitteln des korrespondierenden Drehmoments des Motors;
Schritt c:    Berechnen der thermische Verlustleistung, die zur Erhöhung der Motortemperatur führt, insbesondere durch Subtraktion der mechanischen Wellenleistung von der elektrischen Eingangsleistung und
Schritt d:    die ermittelte thermische Verlustleistung wird als Eingangsgröße zur Lösung des Differentialgleichungssystems in das Differentialgleichungssystem eingespeist und daraus eine Temperaturerhöhung berechnet, insbesondere unter Verwendung einer zusätzlichen Referenztemperatur $T_{ref}$, die zur Temperaturerhöhung addiert wird, um daraus die Motortemperatur zu bestimmen.

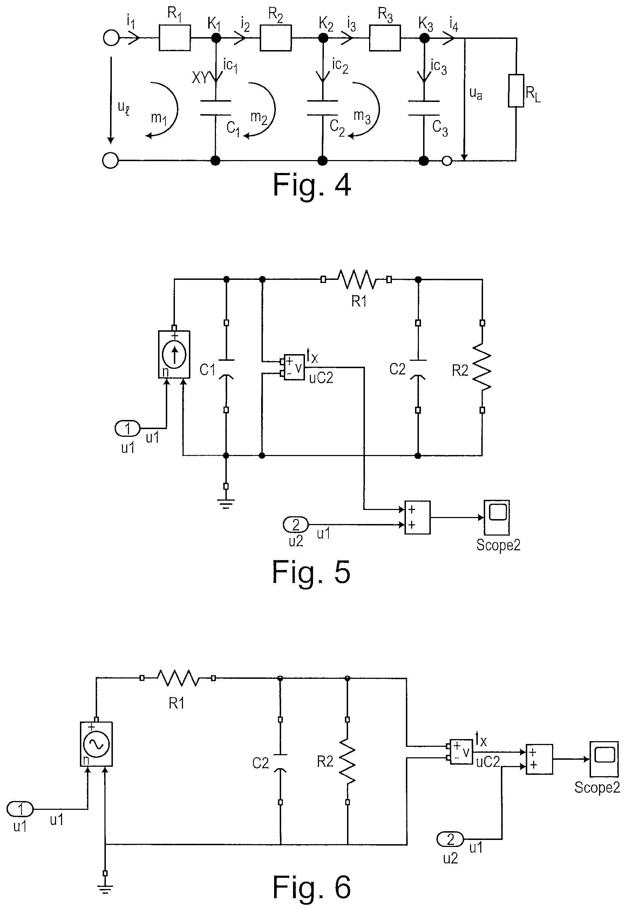

In einer ersten ausführungsform bei Verwendung der numerischen Integration zum Lösen der Differentialgleichungen, sind die Schritte a) bis d) wie folgt charakterisiert.
Im Folgenden wird ein beispielhaftes Realisierungskonzept für eine RC-Kettenschaltung gemäß der Fig. 4. Bei der RC-Kettenschaltung sind drei parallele RC-Maschen mit den Widerständen $R_1$, $R_2$, $R_3$, $R_L$ und den Kondensatoren C1, C2, C3 realisiert. Ferner sind die Knoten K1, K2 und K3 angegeben an denen sich die Ströme i1, i2 und i3 bzw. $i_{c1}$, $i_{c2}$ und $i_{c3}$ aufteilen. Zum ersten Knoten K1 fließt der Strom i1 und teilt sich dann in den Strom i2 und $i_{c1}$ auf. Aus der Figur 4 ist ersichtlich, wie sich die Ströme entsprechend auf die Maschen aufteilen. Zwischen den Anschlüssen liegt die Spannung $U_R$ an. Der Spannungsabfall an den Kondensatoren C1, C2, C3 wird mit $U_{C1}$, $U_{C2}$ und $U_{C3}$ bezeichnet. Mit $U_e$ wird die Spannung am Eingang und mit $U_a$ die Spannung am Ausgang bezeichnet.
Es gelten dabei folgende Zusammenhänge:

$$U_R = i_1 R_1 + U_{C1}$$

$$
\begin{aligned}
&\text{K1:} \quad i_1 = i_{c1} + i_2 \rightarrow (i_1 - i_2) \cdot 1/C1 = dU_{C1}/dt \\
&\text{K2:} \quad i_2 = i_{c2} + i_3 \rightarrow (i_2 - i_3) \cdot 1/C2 = dU_{C2}/dt \\
&\text{K2:} \quad i_3 = i_{c3} + i_4 \rightarrow (i_3 - i_4) \cdot 1/C3 = dU_{C3}/dt
\end{aligned}
$$

Für $i_4$ gilt $i_4 = 0$ (ohne Last)
$i_4 = U_{C3}/R_L$ (mit Last)
Die Ströme stehen jeweils für eine thermische Leistung und die Spannungen für Temperaturen. Das thermische Modell wird somit in Analogie zu dem dargestellten elektrischen Modell gerechnet. Somit stehen dann die elektrischen Widerstände in Analogie zu den thermischen Widerständen und repräsentieren die Kondensatoren die Wärmekapazitäten.
Bei den Nebenbedingungen

$$
\begin{aligned}
&\text{M1:} \quad (U_e - U_{C1}) \cdot 1/R_1 = i_1 \\
&\text{M2:} \quad (U_{C1} - U_{C2}) \cdot 1/R_2 = i_2 \\
&\text{M3:} \quad (U_{C2} - U_{C3}) \cdot 1/R_3 = i_3
\end{aligned}
$$

Bei der Speisung mit einer Stromquelle ist $i_1$ vorgegeben bzw. eingeprägt, wodurch die Gleichung M1 obsolet wird (wie zuvor erläutert in der Analogie der Berechnung betrachtet.)
Für den Zustandsraum gelten dann folgende Zusammenhänge:

$$\frac{dU_{C1}}{dt} = \frac{1}{C1} \cdot \left( \frac{U_e}{R_1} - \frac{U_{C1}}{R_1} - \left( \frac{U_{C1}}{R_2} - \frac{U_{C2}}{R_2} \right) \right)$$

$$\frac{dU_{C2}}{dt} = \frac{1}{C2} \cdot \left( \frac{U_{C1}}{R_2} - \frac{U_{C2}}{R_2} - \left( \frac{U_{C2}}{R_3} - \frac{U_{C3}}{R_3} \right) \right)$$

$$\frac{dU_{C3}}{dt} = \frac{1}{C3} \cdot \left( \frac{U_{C2}}{R_3} - \frac{U_{C3}}{R_3} - (i_4) \right)$$

wobei

$$i_4 = \frac{U_{C3}}{R_L}$$

$$\begin{pmatrix} \frac{dU_{C1}}{dt} \\ \frac{dU_{C2}}{dt} \\ \frac{dU_{C3}}{dt} \end{pmatrix} = \begin{pmatrix} \frac{-1}{R_1 C_1} - \frac{1}{R_2 C_1} & \frac{1}{R_2 C_1} & 0 \\ \frac{1}{R_2 C_2} & \frac{-1}{R_2 C_2} - \frac{1}{R_3 C_2} & \frac{1}{R_3 C_2} \\ 0 & \frac{1}{R_3 C_3} & \frac{-1}{R_3 C_3} - \frac{1}{R_L C_3} \end{pmatrix} \cdot \begin{pmatrix} U_{C1} \\ U_{C2} \\ U_{C3} \end{pmatrix} + U_R \begin{pmatrix} \frac{1}{R_1 C_1} \\ 0 \\ 0 \end{pmatrix}$$

Die Erfassung der elektrischen Eingangsleistung (zur Speisung des thermischen DGL-Systems) kann beispielsweise durch Messung der Zwischenkreisspannung und des Zwischenkreisstroms (zwei AD-Kanäle) erfolgen und durch die Multiplikation der beiden Werte in einem dazu implementierten Mikrorechner.

Die Berechnung der mechanischen Wellenleistung kann aus der Drehzahl (über die Messung der Frequenz der Strangspannung mithilfe von Timern) und Berechnung des dazugehörigen Drehmomentes aus einem entsprechend gespeicherten Kennfeld erfolgen. Alternativ kann das Drehmoment über den Strom iq (welcher mithilfe der Rotorlage und des dreiphasigen Strangstromes berechnet werden kann oder vom Kommutierungsprogram zur Verfügung gestellt wird, berechnet werden. Alternativ kann das Drehmoment auch mithilfe eines Dehnungsmessstreifens gemessen werden.

Es erfolgt die Subtraktion der mechanischen Wellenleistung von der elektrischen Eingangsleistung und diese Differenz ergibt die thermische Leistung (nämlich: Verlustleistung) welche zur Erwärmung des Motors führt. Die magnetische Leistung in der Eingangsleistung, welche ja reversible Blindleistung darstellt, ist nur bei Änderung des Strangstromes (des Effektivwertes) vorhanden und kann bei Bedarf bei häufigen Drehzahl und Laständerungen mit erfasst werden z.B. über eine entsprechend abhängige Konstante, Kennfeld, oder als Eingabewert aus einer Rechenschaltung zur genauen Berechnung der Leistungsbilanz. Die Erwärmung, welche durch den Strom (durch die Wicklungswiderstände) zur Speicherung der magnetischen Leistung (Blindleistung), erfolgt, wird jedoch automatisch berücksichtigt.

Die berechnete thermische Leistung (Verlustleistung) wird nun in das Differentialgleichungssystem als Eingangsgröße eingespeist und daraus eine Temperaturerhöhung infolge dieser Leistung berechnet. Die mithilfe des Differentialgleichungssystems und der Eingangsleistung berechnete Temperaturerhöhung wird nun noch zur gemessenen Referenztemperatur addiert und man erhält die geschätzte Temperatur im Motorinnenraum.

Danach kann die Ausgabe der Temperatur z. B. als analoges Signal über einen DA-Wandler beliebiger Ausführung, über einen Datenbus oder als binärer Schwell-und Alarmwert an einem Pin erfolgen.

In einer zweiten Ausführungsform erfolgt die Verwendung der analogen Berechnung. Das Differentialgleichungssystem wird somit analog berechnet und zwar indem die entsprechende Schaltung nach der Art eines Analogrechners auf der Leiterkarte (PCB) aufgebaut wird. Es werden dazu die erforderlichen Opperationsverstärker, Addierer, Subtrahierer, Konstanten Potentiometer (Multiplikation mit Konstanten), Funktionengeneratoren (für die Drehmomentkennlinie(n)) und Integratoren benötigt. Mit diesen erfolgen dann die Schritte a) bis d) wie folgt:

Die Erfassung der elektrischen Eingangsleistung erfolgt vorzugweise aus dem Zwischenkreis mithilfe von geeigneten Spannungsteilern für die Zwischenkreisspannung und Shunts zur Strommessung sowie von Operationsverstärkern (OP) zur Signalverstärkung. Die Multiplikation zur Berechnung der Eingangsleistung geschieht dann mithilfe dazu geeigneter OP-Schaltungen (Multiplizierern) oder mithilfe von speziellen (analogen oder digitalen) Multiplizierbausteinen (Modulationsverfahren oder Berechnungen). Sollte die Zwischenkreisspannung konstant sein und die Konstanz auch überwacht werden, genügt es, den gemessenen Strom, mit einer konstanten Verstärkung, in die Eingangsleistung zu übertragen.

Mithilfe einer analogen Frequenz-Spannungswandlung kann aus der Strangspannung des Motors eine der Drehzahl proportionalen Spannung erzeugt werden. Multipliziert man diese Spannung mithilfe eines analogen Multiplizieres oder eines gesteuerten Verstärkers (Steuerung der Verstärkung) mit einer dem Drehmoment proportionalen Spannung, erhält man die Wellenleistung.

Eine solche dem Drehmoment proportionale Spannung kann Beispielsweise mithilfe eines analogen oder digitalen Funktionen-Generators (die Drehzahl ist dann die Eingangsgrösse) gewonnen werden. Dem Funktionen-Generator ist hierzu z. B. die Kennlinie des vom Motor angetriebenen Lüfter-Rades hinterlegt.

Die Subtraktion der mechanischen Wellenleistung von der elektrischen Eingangsleistung ergibt auch hier die thermische Leistung (Verlustleistung) welche zur Erwärmung des Motors führt. Diese thermische Leistung wird nun wie in dem zuvor genannten Ausführungsbeispiel dem Differentialgleichungssystem als Eingangsgröße, zur Berechnung der Motortemperatur zugeführt.

Wird das Differentialgleichungssystem mit einer Spannung gespeist, deren Wert der thermischen Verlustleistung entspricht, liefert das Differentialgleichungssystem an seiner letzten Kapazität die gewünschte Temperaturerhöhung. Wird das Differentialgleichungssystem mit der thermischen Verlustleistung als Stromquelle gespeist, liefert die Spannung an der ersten Kapazität die gewünschte Temperaturerhöhung.

Die mithilfe des analogen Differentialgleichungssystem und der Eingangsleistung berechnete Temperaturerhöhung wird nun noch zur gemessenen Referenztemperatur addiert und man erhält die "geschätzte" Temperatur im Motorinnenraum. Die zuvor genannte Addierschaltung liefert nun eine der Motortemperatur proportionale analoge Ausgangsspannung, welche z. B. einfach angezeigt und/oder weitergeleitet werden kann oder mithilfe eines Komparators zur Abschaltung des Motors dienen kann.

In einer dritten Ausführungsform der Figur 1 erfolgt ebenfalls die Verwendung einer analogen Berechnung. Hierzu macht man sich zu Nutze, dass es bei der Entwicklung elektronischer Analogrechner Lösungen gibt, Probleme durch das Bilden direkter (elektrischer) Analogien mit Hilfe passiver Elemente wie Widerständen, Kondensatoren und Spulen anzugehen. Die zu Grunde gelegten Pfade können mit einem Netzwerk von Widerständen modelliert werden. Wenn man z. B. mit Wechselspannung gespeist wird oder eine Spannung im Impulsbetrieb zwischen dem Eingang und/oder Kapazitäten und Induktivitäten und dem Ausgang anlegt, findet man den kürzesten Pfad, indem man an jedem Knoten dem größten Stromfluss folgt. Das Grundprinzip der Lösung beruht auf der Stromaufteilung durch ein Widerstandsnetzwerk mit parallelen und seriellen Elementen. Solche Systeme werden auch als analoge zelluläre Automaten bezeichnet. Mithilfe eines solchen angepassten RC-Netzwerkes (Widerstände und Kondensatoren) lässt sich somit, nach dem Kalibrieren (d. h. Bestimmung der R und C Werte) das reale Temperaturverhalten des Motors nachbilden. Der verwendete zelluläre Automat kann auch eine einfache RC-Kettenschaltung sein.

Bei diesem Ausführungsbeispiel erfolgen dann die Schritte a) bis d) wie folgt:

Die Erfassung der elektrischen Eingangsleistung erfolgt mithilfe von passend dimensionierten Spannungsteilern für die Zwischenkreisspannung und Shunts zur Strommessung sowie von Operationsverstärkern (OP) zur Signalverstärkung. Die Multiplikation zur Berechnung der Eingangsleistung geschieht dann mithilfe dazu geeigneter OP Schaltungen (Multiplizierern) oder mithilfe von speziellen (analogen oder digitalen) Multiplizierbausteinen (Modulationsverfahren oder Berechnung).

Die Ermittlung der Wellenleistung erfolgt analog der zum zweiten Ausführungsbeispiel beschriebenen Schritte. Die Subtraktion der mechanischen Wellenleistung von der elektrischen Eingangsleistung ergibt die thermische Leistung (Verlustleistung) welche zur Erwärmung des Motors führt. Für die Subtraktion und die Speisung des RC-Netzwerkes mit gesteuerten Quellen werden Operationsverstärkerschaltungen verwendet, ebenso wie für die weiteren in diesem Ansatz genannten mathematischen Operationen und/oder Transistorschaltungen. Das eigentliche RC-Netzwerk ist hier als passiv anzusetzen. Wird das RC-Netzwerk mit einer Spannungsquelle (Figur 6) gespeist, deren Wert der thermischen Verlustleistung entspricht, liefert das Ende (Spannung am Lastwiderstand bzw. an der letzten Kapazität) der korrespondierenden RC- Kette die gewünschte Temperaturerhöhung. Wird hingegen das RC-Netzwerk mit der thermischen Verlustleistung als Stromquelle (Figur 5) gespeist, liefert der Anfang (Spannung an der Stromquelle bzw. an der ersten Kapazität) der RC Kette die gewünschte Temperaturerhöhung.

In der Figur 5 sind ein CRCR-Netzwerk und eine Speisung mit einer gesteuerten Stromquelle dargestellt. Das Steuersignal der Stromquelle bildet die besagte berechnete thermische Verlustleistung. Die Stromquelle kann z. B. nach Tietze Schenk mit Operationsverstärkern ausgelegt werden.

In der Figur 6 sind ein CRCR-Netzwerk und eine Speisung mit einer gesteuerten Spannungsquelle dargestellt. Das Steuersignal der Spannungsquelle bildet die besagte berechnete thermische Verlustleistung. Die Bauelemente für R und C werden anhand eines Parameterfit anhand der gemessenen Werte am realen Motor bestimmt. Die Spannungsquelle kann z. B. nach Tietze Schenk mit Operationsverstärkern ausgelegt werden.

Die Messung der jeweiligen Spannungen am RC-Netzwerk (OP-Schaltung) bei Speisung des RC- Netzwerkes mit Spannungs- oder Stromquellen liefert nun die Temperaturerhöhung. Zu dieser Temperaturerhöhung (analoge Spannung) wird noch die gemessene Umgebungstemperatur in Form einer analogen Spannung addiert.

Das thermische Modell kann in beliebigen Ausführungsformen realisiert und berechnet werden, je nachdem wie die Anforderungen sind. Diese Idee entspricht dem erfindungsgemäßen Baukastensystem bzw. der Baukastenlösung.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

**Patentansprüche**

1. System (1) zur Überwachung der Temperatur eines Motors (M) mit einer elektromechanisch antreibbaren Motorwelle, umfassend ein Sensor (10), der basierend auf einem thermischen Modell (MOD), welches das thermische Verhalten des Motors (M) beschreibt, ein Messmittel zur Bestimmung der elektrischen Eingangsleistung (P) des Motors (M) und einem Messmittel zur Erfassung der Wellendrehzahl n der Motorwelle, wobei ferner eine Auswertevorrichtung vorgesehen ist, die ausgebildet ist, aus der Eingangsleistung (P), einer Referenztemperatur $T_{Ref}$, der ermittelten Wellendrehzahl n und dem thermischen Modell (MOD) die jeweils aktuelle Motortemperatur des Motors (M) zu ermitteln, **dadurch gekennzeichnet, dass** die Drehzahl durch Messung der Frequenz einer Strangspannung und ein korrespondierendes Drehmoment des Motors (M) aus einem entsprechend gespeicherten Kennfeld ermittelbar ist, oder mittels des q-Anteils des Stroms iq oder mithilfe eines Dehnungsmessstreifens, wobei mithilfe einer analogen Frequenz-Spannungswandlung aus der zu messenden Strangspannung des Motors eine der Drehzahl proportionalen Spannung erzeugbar ist, um daraus die Wellenleistung zu ermitteln.

2. System (1) nach Anspruch 1, **dadurch gekennzeichnet, dass** das thermischen Modell (MOD) ein Differentialgleichungssystems (DGL) umfasst, welches das thermische Verhalten des Motors (M) nachbildet.

3. System (1) nach Anspruch 2, **dadurch gekennzeichnet, dass** das Differentialgleichungssystems (DGL) als Baukastensystem mehrere alternative Lösungsverfahren zur Ermittlung der Temperatur zulässt, insbesondere mittels nummerischer Integration, mittels analoger Berechnungsmethode auf Basis eines analogen Rechners oder mittels analoger Berechnungsmethode mittels eines Modells umfassend passive Bauelemente.

4. Verfahren zur Überwachung der Temperatur eines Motors (M), mit einem System nach einem der Ansprüche 1 bis 3 unter Verwendung eines Differentialgleichungssystems (DGL), welches das thermische Verhalten des Motors (M) beschreibt, mit den folgenden Schritten:

   a. Erfassung der elektrischen Eingangsleistung des Motors;
   b. Ermittlung einer Drehzahl des Motors (M) durch Messung der Frequenz einer Strangspannung und Ermitteln eines korrespondierenden Drehmomentes des Motors (M), wobei die Ermittlung des korrespondierenden Drehmoments aus einem entsprechend gespeicherten Kennfeld erfolgt, oder mittels des q-Anteils des Stroms iq oder mithilfe eines Dehnungsmessstreifens;
   c. Berechnen der mechanischen Wellenleistung aus der in Schritt b) ermittelten Drehzahl des Motors (M), wobei mithilfe einer analogen Frequenz-Spannungswandlung aus der zu messenden Strangspannung des Motors eine der Drehzahl proportionale Spannung erzeugt wird, um daraus die Wellenleistung zu ermitteln;
   d. Berechnen der thermischen Verlustleistung, die zur Erhöhung der Motortemperatur führt, insbesondere durch Subtraktion der mechanischen Wellenleistung von der elektrischen Eingangsleistung;
   e. die ermittelte thermische Verlustleistung wird als Eingangsgröße zur Lösung des Differentialgleichungssystems (DGL) in das Differentialgleichungssystem (DGL) eingespeist und daraus eine Temperaturerhöhung berechnet, insbesondere unter Verwendung einer zusätzlichen Referenztemperatur $T_{ref}$, die zur Temperaturerhöhung addiert wird, um daraus die Motortemperatur zu bestimmen.

5. Verfahren nach Anspruch 4, **dadurch gekennzeichnet, dass** die Lösung des Differentialgleichungssystems (DGL) zur Ermittlung der Motortemperatur durch numerische Integration erfolgt.

6. Verfahren nach Anspruch 4, **dadurch gekennzeichnet, dass** die Lösung des Differentialgleichungssystems (DGL) zur Ermittlung der Motortemperatur analog berechnet wird, indem eine korrespondierende Schaltung nach der Art eines Analogrechners mit entsprechenden Rechnerbausteinen verwendet wird oder auf Basis frei programmierbarer Schaltungen oder mittels geeigneter RC-Bausteine und passiven Bauelementen.

7. Verfahren nach Anspruch 4 oder 5, **dadurch gekennzeichnet, dass** die Erfassung der elektrischen Eingangsleistung des Motors durch Messung einer Zwischenkreisspannung und eines Zwischenkreisstroms und durch Multiplikation der beiden Messwerte, vorzugsweise mittels Mikrorechner oder programmierbarer Schaltungen erfolgt.

**Claims**

1. A system (1) for monitoring the temperature of a motor (M) with an electromechanically drivable motor shaft, comprising a sensor (10) that is based on a thermal model (MOD), which describes the thermal behavior of the motor (M), a measuring means for determining the electrical input power (P) of the motor (M), and a measuring means for recording the shaft speed n of the motor shaft, wherein an evaluation device is also provided, which is designed to determine the respectively current motor temperature of the motor (M) from the input power (P), a reference temperature $T_{ref}$, the determined shaft speed n, and the thermal model (MOD), **characterized in that** the speed is determinable by measuring the frequency of a phase voltage and a corresponding torque of the motor by means from a correspondingly stored characteristic map determinable, or by means of the q component of the current iq, or by means of a strain gauge, wherein a voltage proportional to the speed is generated from a phase voltage of the motor to be measured with the aid of an analog frequency-voltage conversion in order to determine the shaft power therefrom.

2. The system (1) according to claim 1, **characterized in that** the thermal model (MOD) comprises a differential equation system (DGL) which simulates the thermal behavior of the motor (M).

3. The system (1) according to claim 2, **characterized in that** the differential equation system (DGL), as a modular system, enables several alternative solution methods for determining the temperature, in particular by means of numerical integration, by means of an analog calculation method based on an analog computer, or by means of an analog calculation method by means of a model comprising passive components.

4. A method for monitoring the temperature of a motor (M), with a system according to any of claims 1 to 3, using a differential equation system (DGL) which describes the thermal behavior of the motor (M), with the following steps:

   a. recording the electrical input power of the motor;
   b. Determining a speed of the motor (M) by measuring the frequency of a phase voltage and determining a corresponding torque of the motor (M), wherein determining the corresponding torque from a correspondingly stored characteristic map, or by means of the q component of the current iq, or by means of a strain gauge
   c. calculating the mechanical shaft power from the in step b) determined speed of the motor (M), wherein a voltage proportional to the speed is generated from a phase voltage of the motor to be measured with the aid of an analog frequency-voltage conversion in order to determine the shaft power therefrom.
   d. calculating the thermal power loss that leads to the increase in motor temperature, in particular by subtracting the mechanical shaft power from the electrical input power;
   e. the determined thermal power loss is fed into the differential equation system (DGL) as an input variable for solving the differential equation system (DGL), and a temperature increase is calculated therefrom, in particular using an additional reference temperature $T_{ref}$, which is added to the temperature increase in order to determine the motor temperature therefrom.

5. The method according to claim 4, **characterized in that** the differential equation system (DGL) for determining the motor temperature is solved by numerical integration.

6. The method according to claim 4, **characterized in that** the solution of the differential equation system (DGL) for determining the motor temperature is calculated analogously by using a corresponding circuit in the manner of an analog computer with corresponding computer modules or on the basis of freely programmable circuits or by means of suitable RC modules and passive components.

7. The method according to claim 4 or 5, **characterized in that** the electrical input power of the motor is recorded by measuring an intermediate circuit voltage and an intermediate circuit current and by multiplying the two measured values, preferably by means of a microcomputer or programmable circuits.

**EP 4 057 502 B1**

### Revendications

1. Système (1) pour la surveillance de la température d'un moteur (M) avec un arbre moteur à entraînement électromécanique, comprenant un capteur (10), qui est basé sur un modèle thermique (MOD), lequel décrit le comportement thermique du moteur (M), un moyen de mesure pour la détermination de la puissance d'entrée électrique (P) du moteur (M) et un moyen de mesure pour la détection du régime de l'arbre n de l'arbre moteur, dans lequel est en outre prévu un dispositif d'évaluation, qui est conçu pour déterminer la température de moteur respectivement actuelle du moteur (M) à partir de la puissance d'entrée (P), d'une température de référence $T_{Ref}$, du régime d'arbre n déterminé et du modèle thermique (MOD), **caractérisé en ce que** le régime est déterminable par mesure de la fréquence d'une tension de phase et un couple correspondant du moteur (M) à partir d'un champ caractéristique enregistré en conséquence, ou au moyen de la partie q du courant iq ou à l'aide d'une jauge de contrainte, dans lequel, à l'aide d'une conversion analogique fréquence-tension, une tension proportionnelle au régime peut être générée à partir de la tension de phase à mesurer du moteur, pour en déterminer la puissance d'arbre.

2. Système (1) selon la revendication 1, **caractérisé en ce que** le modèle thermique (MOD) comprend un système d'équations différentielles (DGL), lequel simule le comportement thermique du moteur (M).

3. Système (1) selon la revendication 2, **caractérisé en ce que** le système d'équations différentielles (DGL) en tant que système modulaire permet plusieurs procédés de solution alternatifs pour la détermination de la température, en particulier au moyen d'une intégration numérique, au moyen d'une méthode de calcul analogique basée sur un calculateur analogique ou au moyen d'une méthode de calcul analogique au moyen d'un modèle comprenant des composants passifs.

4. Procédé pour la surveillance de la température d'un moteur (M), avec un système selon l'une des revendications 1 à 3 en utilisant un système d'équations différentielles (DGL), lequel décrit le comportement thermique du moteur (M), avec les étapes suivantes :

   a. la détection de la puissance d'entrée électrique du moteur ;
   b. la détermination d'un régime du moteur (M) par mesure de la fréquence d'une tension de phase et la détermination d'un couple correspondant du moteur (M), dans lequel la détermination du couple correspondant s'effectue à partir d'un champ caractéristique enregistré en conséquence, ou au moyen de la partie q du courant iq ou à l'aide d'une jauge de contrainte ;
   c. le calcul de la puissance d'arbre mécanique à partir du régime du moteur (M) déterminé à l'étape b), dans lequel, à l'aide d'une conversion analogique fréquence-tension, une tension proportionnelle au régime est générée à partir de la tension de phase à mesurer du moteur, pour en déterminer la puissance d'arbre ;
   d. le calcul de la puissance perdue thermique, qui mène à l'augmentation de la température de moteur, en particulier par soustraction de la puissance d'arbre mécanique de la puissance d'entrée électrique ;
   e. l'injection de la puissance perdue thermique déterminée comme grandeur d'entrée pour la solution du système d'équations différentielles (DGL) dans le système d'équations différentielles (DGL) et à partir de là, une augmentation de température est calculée, en particulier en utilisant une température de référence $T_{ref}$ supplémentaire, qui est ajoutée à l'augmentation de température, pour en déterminer la température de moteur.

5. Procédé selon la revendication 4, **caractérisé en ce que** la solution du système d'équations différentielles (DGL) pour la détermination de la température de moteur s'effectue par intégration numérique.

6. Procédé selon la revendication 4, **caractérisé en ce que** la solution du système d'équations différentielles (DGL) pour la détermination de la température de moteur est calculée de manière analogique, en utilisant un circuit correspondant de type calculateur analogique avec des blocs de calcul correspondants ou sur la base de circuits librement programmables ou au moyen de blocs RC appropriés et de composants passifs.

7. Procédé selon la revendication 4 ou 5, **caractérisé en ce que** la détection de la puissance d'entrée électrique du moteur s'effectue par la mesure d'une tension de circuit intermédiaire et d'un courant de circuit intermédiaire et par la multiplication des deux valeurs de mesure, de préférence au moyen d'un microcalculateur ou de circuits programmables.

| Erfassung der elektrischen Eingangsleistung | Schritt a |

| Wellenleistung aus der erfassten Drehzahl | Schritt b |

| thermische Verlustleistung | Schritt c |

| Lösung des Differentialgleichungssystems (DGL) | Schritt d |

Temperatur des Motors

# Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008040725 A1
- EP 2977733 A1
- DE 102019105081 A1
- EP 3107204 A1
- US 2020341062 A1
- US 5600575 A
- US 6349023 B1
- US 2020400355 A1